# EUROPEAN PATENT SPECIFICATION

(11) **EP 3 204 266 B1**
(45) Date of publication and mention of the grant of the patent: **18.04.2018**
(21) Application number: 15837138.5
(22) Date of filing: 17.12.2015
(51) Int. Cl.: H03K 17/96, B60K 37/06, B60R 25/23, B60R 25/24, G07C 9/00

(54) **CAPACITVE KEYPAD, VEHICLE TRIM COMPONENT, VEHICLE, AND METHOD FOR IMPLEMENTING SUCH CAPACITIVE KEYPAD**
KAPAZITIVE TASTATUR, KRAFTFAHRZEUGVERKLEIDUNGSKOMPONENTE, FAHRZEUG UND VERFAHREN ZUR IMPLEMENTIERUNG SOLCH EINER KAPAZITIVEN TASTATUR
CAPACITIVE KEYPAD, VEHICLE TRIM COMPONENT, VEHICLE, AND METHOD FOR IMPLEMENTING SUCH CAPACITIVE KEYPAD

(43) Date of publication of application: 16.08.2017
(73) Proprietor: Dura Automotive Systems SAS, 91570 Bièvres (FR)
(72) Inventor: FARGES, Thomas, 91940 Gometz Le Chatel (FR)
(74) Representative: Cabinet Laurent & Charras
(86) International application number: PCT/IB2015/002594
(87) International publication number: WO 2017/103644

(56) References cited:
- WO-A1-2015/168459
- CA-A1- 2 894 297
- US-A1- 2010 315 267

## Description

### TECHNICAL FIELD OF THE INVENTION

The invention concerns a capacitive keypad, designed to equip a vehicle. The invention also concerns a vehicle trim component and a vehicle equipped with such capacitive keypad. The invention also concerns a method for implementing such capacitive keypad.

The field of the invention is that of capacitive keypads equipping automotive vehicles, especially for unlocking or locking vehicle openings such as doors and rear trunk. Generally, the user of the capacitive device is the vehicle driver.

### BACKGROUND OF THE INVENTION

CA2894297A1 discloses an example of capacitive keypad, configured to interact with a user via a swipe-up input. The vehicle controller is configured to control the vehicle operation in response to detecting the swipe-up input on the capacitive keypad, or another input via an application independent of the swipe-up input, within a predetermined time.

US2010315267A1 discloses an example of capacitive keypad, configured to unlock vehicle doors by pressing a series of keys according to a predetermined sequence, and to lock the doors by pressing two particular keys during a predetermined time.

WO2015168459A1 discloses another example of capacitive keypad, integrating a NFC device.

In practice, inadvertent actuation of capacitive keys may occur. Such inadvertent actuation may be exacerbated by environmental factors such as rain, frost, and condensation. In some instances, a user may touch one capacitive key and moisture on the keypad may cause cross-talk with another capacitive key. Thus, a complex touch area suppression algorithm is provided to prevent inadvertent actuation from cross-talk.

### SUMMARY OF THE INVENTION

The aim of the invention is to provide an improved capacitive keypad, having an improved sensor arrangement.

To this end, the invention concerns a capacitive keypad, designed to equip a vehicle, comprising several capacitive keys and configured to activate particular functions, including a primary lock function, consisting in locking or unlocking at least one vehicle opening; and a secondary lock function, consisting in locking the at least one vehicle opening by a user equipped with a passive entry device. According to the invention, the particular functions further include an antiswipe function, consisting in deactivating one of the lock functions among the primary lock function and the secondary lock function, upon droplet detection or finger slippage detection. Furthermore, a single specific key among the capacitive keys is configured to selectively activate either the secondary lock function or the antiswipe function of the capacitive keypad.

Thanks to the invention, the capacitive keypad is provided with several functions while being compact, in comparison with a capacitive keypad having separated functions associated with separated capacitive keys.

Moreover, the invention allows reducing the number of printed tracks arranged under the capacitive keys acting as sensors, the number of connectors linking the sensors arranged on the printed tracks to an electronic card, and the size of the processor arranged on the electronic card.

According to further aspects of the invention which are advantageous but not compulsory, such a capacitive keypad may incorporate one or several of the following features:
- The antiswipe function is configured to deactivate the primary lock function, upon droplet detection or finger slippage detection by the specific key.
- The antiswipe function is configured to deactivate the secondary lock function, upon droplet detection or finger slippage detection by an other key than the specific key.
- The other key is positioned directly next to the specific key.
- The other key is positioned directly above the specific key.
- The specific key is positioned under other capacitive keys.
- The specific key displays a padlock symbol.
- The specific key displays a closed padlock symbol when the at least one vehicle opening is closed and an opened padlock symbol when the at least one vehicle opening is opened.
- The primary lock function and the secondary lock function are associated with all vehicle openings, including several doors and at least one trunk.

The invention also concerns a method for implementing a capacitive keypad as mentioned here-above, wherein the method comprises a step of selectively activating the secondary lock function or the antiswipe function of the capacitive keypad by contacting the specific key.

Preferably, the antiswipe function is automatically activated upon droplet detection or finger slippage detection by the specific key, while the secondary lock function is manually activated by a user equipped with a passive entry device and pressing the specific key.

The invention also concerns a capacitive keypad, designed to equip a vehicle, comprising several capacitive keys and configured to activate particular functions including a primary lock function, consisting in locking or unlocking at least one vehicle opening; and a secondary lock function, consisting in locking the at least one vehicle opening by a user equipped with a passive entry device. According to the invention, the particular functions further include an antiswipe function, consisting in deactivating one of the lock functions among the primary lock function and the secondary lock function, upon droplet detection or finger slippage detection. Furthermore, a first key among the capacitive keys is configured to activate the antiswipe function for deactivating the primary lock function, while a second key different from the first key is configured to activate the antiswipe function for deactivating the secondary lock function.

The invention also concerns a method for implementing a capacitive keypad as mentioned here-above, wherein the method comprises a step of activating the antiswipe function for deactivating the primary lock function upon droplet detection or finger slippage detection by the first key or for deactivating the secondary lock function upon droplet detection or finger slippage detection by the second key.

The invention also concerns a vehicle trim component equipped with a capacitive keypad as mentioned here-above. Preferably, the vehicle trim component is a vehicle pillar member.

The invention also concerns a vehicle equipped with a capacitive keypad as mentioned here-above.

### BRIEF DESCRIPTION OF THE DRAWINGS

The invention will now be explained in correspondence with the annexed figures, and as an illustrative example, without restricting the object of the invention. In the annexed figures:
- figure 1 is a partial front view of a vehicle trim component according to the invention, equipped with a capacitive keypad also according to the invention, displaying a closed padlock symbol; and
- figure 2 is a view at a larger scale of the capacitive keypad of figure 1;
- figure 3 is a bottom view of the capacitive keypad of figure 2;
- figure 4 is a view similar to figure 2, with the capacitive keypad displaying an opened padlock symbol.

### DETAILED DESCRIPTION OF SOME EMBODIMENTS

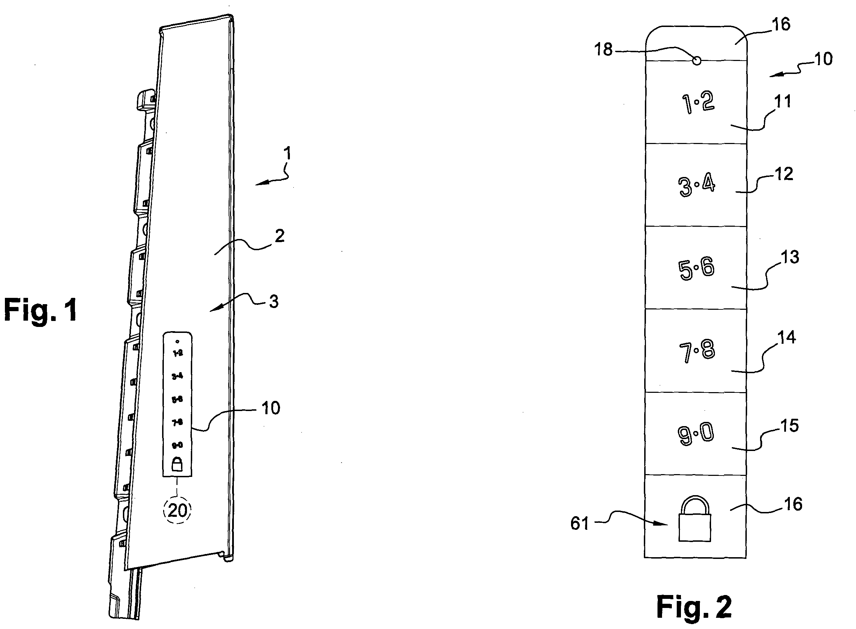

Figures 1 to 4 show a capacitive keypad 10 according to the invention, equipping a vehicle 1 partly represented for simplification purpose.

More precisely, keypad 10 is integrated to a vehicle trim component 2, preferably a vehicle pillar member.

Keypad 10 includes six capacitive keys 11, 12, 13, 14, 15 and 16 connected to an electronic control unit 20 also integrated to component 2. The electric connection between keys 11-16 and unit 20 is done via printed tracks 30, 31, 32, 33, 34, 35, 36 and connectors 40.

Unit 20 may comprise an electronic card formed by a printed circuit board, provided with electronic elements including a processor. Unit 20 is connected to the onboard computer of vehicle 1. Alternatively, unit 20 may be deported to another location of the vehicle 1, or be directly integrated to the onboard computer of vehicle 1.

Keypad 10 has a tactile function, known per se. The tactile function of keypad 10 is enabled by default but can be disabled under certain conditions, as detailed below.

Keys 11-16 can be reached on the external surface 3 of component 2 by a user of vehicle 1. Thus, the user can generate signals directed to the electronic control unit 20 by pressing surface of keys 11-16, acting as pressure sensors.

In particular, some signals are intended to lock the openings of vehicle 1, by typing a numeric code corresponding to a predetermined sequence of keys 11-15. Generally, those openings include the doors and the rear trunk of vehicle 1.

Keypad 10 is a capacitive system, known per se. Keypad 10 includes a capacitive layer designed to accumulate electrical charges. When the user touches the surface of keypad 10 with his finger, some of these charges are transferred to said finger. Charges leaving the capacitive layer create a measurable deficit, allowing detection of a push on a given key 11-16. The capacitance associated to each key 11-16 can be measured and transmitted to unit 20, either continuous or at regular intervals.

For example, the variations of charges may be measured by means of electrodes positioned under keypad 10 and connected to unit 20 via printed tracks 30-36 and connectors 40.

Keys 11-15 each have two digits, namely digits "1" and "2" on key 11, digits "3" and "4" on key 12, digits "5" and "6" on key 13, digits "7" and "8" on key 14, and digits "9" and "0" on key 15. Thus, keypad 10 is more compact in comparison with a keypad provided with ten keys, each having a single digit.

A predetermined pressing sequence on keys 11-15 sends a numeric code to unit 20, which then controls locking or unlocking of the openings of vehicle 1 when the code is correct.

In practice, a push on key 11 sends a signal corresponding to both digits "1" and "2" indistinctly, and so on for keys 12-15. That allows defining a numeric code based on ten digits, without requiring double-pushes for typing even digits.

According to the invention, keypad 10 is configured to activate several particular functions, including a primary lock function, a secondary lock function and an antiswipe function described here-below.

The primary lock function is configured to lock or unlock at least one vehicle opening. The primary lock function is controlled by keys 11-15. For example, locking is activated by simultaneously pressing keys 14 and 15 during a predetermined time (generally around one second), while unlocking is activated by pressing a predetermined sequence of several keys 11-15.

The secondary lock function is configured to lock the at least one vehicle opening by a user equipped with a passive entry device, such as an electronic key fob, in wireless communication with vehicle 1. In the context of the invention, the onboard computer of vehicle 1 is provided with a PEPS function (Passive Entry Passive Start) configured to check if the electronic key fob is located inside or outside vehicle 1.

In practice, the locking is automatically performed when the user equipped with the passive entry device moves away from a certain distance from the vehicle. However, the locking via primary lock function and keys 11-15 cannot be activated when the user is close to the vehicle. Under those conditions, the secondary lock function provides a manual lock function in combination with the use of the passive entry device.

The antiswipe function is configured to deactivate one of the lock functions upon droplet or finger slippage detection, as detailed here-after.

Preferably, the primary lock function and the secondary lock function are associated with all openings, including generally several doors and at least one trunk, of vehicle 1.

According to the invention, key 16 is a specific capacitive key among all keys 11-16, in that key 16 is configured to selectively activate both the secondary lock function and the antiswipe function of keypad 10.

Depending on the pressing sequence on keys 11-16, key 16 is configured to activate either the secondary lock function or the antiswipe function.

Thus, the invention allows reducing the number of printed tracks 30-36 arranged under keys 11-16 acting as sensors, the number of connectors 40 linking the sensors to the electronic card, and the size of the processor arranged on the electronic card.

Besides, since no additional key is arranged between key 16 and connectors 40, the printed track 36 linking key 16 to its connector 40 can be very short.

Preferably, the antiswipe function is automatically activated upon droplet detection or finger slippage detection on key 16, while the secondary lock function is manually activated by a user equipped with a passive entry device and pressing the specific key 16.

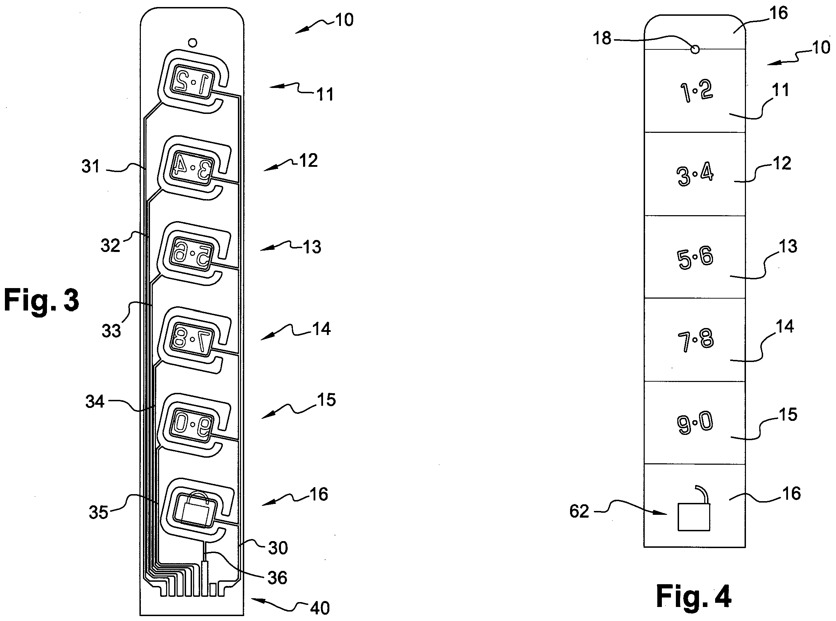

On the example of figures 1 to 4, key 16 is located under other keys 11-15 and displays a padlock symbol. More precisely, key 16 displays a red closed padlock symbol 61 when the openings of vehicle 1 are closed (figures 1 and 2) and a green opened padlock symbol 62 when the openings of vehicle 1 are opened (figure 4).

According to a first embodiment, the anstiswipe function is configured to deactivate the primary lock function upon droplet detection or finger slippage detection on key 16, but not configured to deactivate the secondary lock function.

In case of pressure detection simultaneously on keys 14 and 15, while a pressure has previously been detected by key 16, the anstiswipe function deactivates the primary lock function, which prevents locking of vehicle 1.

In case of pressure detection on keys 11 to 15, while a pressure has previously been detected on key 16, the anstiswipe function deactivates the primary lock function, which prevents unlocking of vehicle 1 if the predetermined unlocking sequence has been fortuitously typed.

According to a second embodiment, the antiswipe function is configured to selectively deactivate the primary lock function or the secondary lock function. More precisely, the anstiswipe function is configured, on the one hand, to deactivate the primary lock function upon droplet or finger slippage detection by key 16, as described here-above and, on the other hand, to deactivate the secondary lock function upon droplet or finger slippage detection by another key, preferably by key 15 located directly above key 16.

In case of pressure detection on key 16, while a pressure has previously been detected by key 15, the anstiswipe function deactivates the secondary lock function, which prevents locking of vehicle 1 by the user equipped with the passive entry device.

In this embodiment, keys 15 or 16 are configured to selectively activate the antiswipe function, but only key 16 is configured to selectively activate both the secondary lock function or the antiswipe function.

Keypad 10 also has a non-capacitive space 17 located above key 11. Alternatively, space 17 may be capacitive and control other features of keypad 10, which will not be described in so far as they are not object of the present invention.

Keypad 10 also includes a light emitting diode 18 between key 11 and space 17, allowing for example to warn the user that he typed a correct or incorrect code

## Claims

1. A capacitive keypad (10), designed to equip a vehicle (1), comprising several capacitive keys (11-16) and configured to activate particular functions, including:
- a primary lock function, consisting in locking or unlocking at least one vehicle opening; and
- a secondary lock function, consisting in locking the at least one vehicle opening by a user equipped with a passive entry device; **characterised in that** the particular functions further include an antiswipe function, consisting in deactivating one of the lock functions among the primary lock function and the secondary lock function, upon droplet detection or finger slippage detection;
and wherein a single specific key (16) among the capacitive keys (11-16) is configured to selectively activate either the secondary lock function or the antiswipe function of the capacitive keypad (10).

2. The capacitive keypad (10) according to claim 1, wherein the antiswipe function is configured to deactivate the primary lock function, upon droplet detection or finger slippage detection by the specific key (16).

3. The capacitive keypad (10) according to any one of the previous claims 1 and 2, wherein the antiswipe function is configured to deactivate the secondary lock function, upon droplet detection or finger slippage detection by an other key (15) than the specific key (16).

4. The capacitive keypad (10) according to claim 3, wherein the other key (15) is positioned directly next to the specific key (16).

5. The capacitive keypad (10) according to any one of the previous claims 3 and 4, wherein the other key (15) is positioned directly above the specific key (16).

6. The capacitive keypad (10) according to any one of the previous claims, wherein the specific key (16) is positioned under other capacitive keys (11-15).

7. The capacitive keypad (10) according to any one of the previous claims, wherein the specific key (16) displays a padlock symbol (61; 62).

8. The capacitive keypad (10) according to any one of the previous claims, wherein the specific key (16) displays a closed padlock symbol (61) when the at least one vehicle opening is closed and an opened padlock symbol (62) when the at least one vehicle opening is opened.

9. The capacitive keypad (10) according to any one of the previous claims, wherein the primary lock function and the secondary lock function are associated with all vehicle openings, including several doors and at least one trunk.

10. A capacitive keypad (10), designed to equip a vehicle (1), comprising several capacitive keys (11-16) and configured to activate particular functions, including:
- a primary lock function, consisting in locking or unlocking at least one vehicle opening; and
- a secondary lock function, consisting in locking the at least one vehicle opening by a user equipped with a passive entry device; **characterised in that** the particular functions further include an antiswipe function, consisting in deactivating one of the lock functions among the primary lock function or the secondary lock function, upon droplet detection or finger slippage detection;
and wherein a first key (16) among the capacitive keys (11-16) is configured to activate the antiswipe function for deactivating the primary lock function, while a second key (15) different from the first key (16) is configured to activate the antiswipe function for deactivating the secondary lock function.

11. A vehicle trim component (2), equipped with a capacitive keypad (10) according to any one of the previous claims 1 to 10.

12. A vehicle (1), equipped with a capacitive keypad (10) according to any one of the previous claims 1 to 10.

13. A method for implementing a capacitive keypad (10) according to any one of the previous claims 1 to 9, wherein the method comprises a step of selectively activating the secondary lock function or the antiswipe function of the capacitive keypad (10) by contacting the specific key (16).

14. The method according to claim 13, wherein the antiswipe function is automatically activated upon droplet detection or finger slippage detection by the specific key (16), while the secondary lock function is manually activated by a user equipped with a passive entry device and pressing the specific key (16).

15. A method for implementing a capacitive keypad (10) according to claim 10, wherein the method comprises a step of activating the antiswipe function for deactivating the primary lock function upon droplet detection or finger slippage detection by the first key (16) or for deactivating the secondary lock function upon droplet detection or finger slippage detection by the second key (15).

## Patentansprüche

1. Ein kapazitiver Touchscreen (10), der zum Einsatz in einem Fahrzeug (1) entwickelt wird, mehrere kapazitive Tasten (11- 16) umfasst und konfiguriert ist, um besondere Funktionen zu aktivieren, einschließlich:
- einer primären Verriegelungsfunktion, die im Ver- oder Entriegeln mindestens einer Fahrzeugöffnung besteht; und
- einer sekundären Verriegelungsfunktion, die darin besteht, dass die mindestens eine Fahrzeugöffnung von einem Benutzer mit einer passiven Zugangsvorrichtung verriegelt wird;
**dadurch gekennzeichnet, dass**
die besonderen Funktionen weiterhin eine Anti-Wisch-Funktion umfassen, die darin besteht, über die Tröpfchen- oder Fingerberührungserkennung eine der Verriegelungsfunktionen der primären und der sekundären Verriegelungsfunktion zu deaktivieren,
und wobei eine einzige spezifische Taste (16) der kapazitiven Tasten (11- 16) konfiguriert ist, um selektiv entweder die sekundäre Verriegelungsfunktion oder die Anti-Wisch-Funktion des kapazitiven Touchscreens (10) zu aktivieren.

2. Kapazitiver Touchscreen (10) gemäß Anspruch 1, wobei die Anti-Wisch-Funktion konfiguriert ist, um über die Tröpfchen- oder Fingerberührungserkennung mittels der spezifischen Taste (16) die primäre Verriegelungsfunktion zu deaktivieren.

3. Kapazitiver Touchscreen (10) gemäß einem der Ansprüche 1 und 2, wobei die Anti-Wisch-Funktion konfiguriert ist, um die sekundäre Verriegelungsfunktion über die Tröpfchen- oder Fingerberührungserkennung mittels irgendeiner anderen Taste (15) als der spezifischen Taste (16) zu deaktivieren.

4. Kapazitiver Touchscreen (10) gemäß Anspruch 3, wobei die andere Taste (15) direkt neben der spezifischen Taste (16) positioniert ist.

5. Kapazitiver Touchscreen (10) gemäß einem der vorstehenden Ansprüche 3 und 4, wobei die andere Taste (15) direkt über der spezifischen Taste (16) positioniert ist.

6. Kapazitiver Touchscreen (10) gemäß einem der vorstehenden Ansprüche, wobei die spezifische Taste (16) unter anderen kapazitiven Tasten (11- 15) positioniert ist.

7. Kapazitiver Touchscreen (10) gemäß einem der vorstehenden Ansprüche, wobei die spezifische Taste (16) ein Schloss- Symbol (61, 62) zeigt.

8. Kapazitiver Touchscreen (10) gemäß einem der vorstehenden Ansprüche, wobei die spezifische Taste (16) das Symbol eines geschlossenen Schlosses (61), wenn mindestens eine Fahrzeugöffnung geschlossen ist und das Symbol eines offenen Schlosses (62), wenn mindestens eine Fahrzeugöffnung offen ist, zeigt.

9. Kapazitiver Touchscreen (10) gemäß einem der vorstehenden Ansprüche, wobei die primäre Verriegelungsfunktion und die sekundäre Verriegelungsfunktion mit allen Fahrzeugöffnungen verbunden sind, einschließlich verschiedener Türen und mindestens dem Koffer- bzw. Motorraum.

10. Kapazitiver Touchscreen (10), der zum Einsatz in einem Fahrzeug (1) entwickelt wird, mehrere kapazitive Tasten (11- 16) umfasst und konfiguriert ist, um besondere Funktionen zu aktivieren, einschließlich:
- einer primären Verriegelungsfunktion, die im Ver- oder Entriegeln mindestens einer Fahrzeugöffnung besteht; und
- einer sekundären Verriegelungsfunktion, die darin besteht, dass die mindestens eine Fahrzeugöffnung von einem Benutzer mit einer passiven Zugangsvorrichtung verriegelt wird;
**dadurch gekennzeichnet, dass**
die besonderen Funktionen weiterhin eine Anti-Wisch-Funktion umfassen, die darin besteht, über die Tröpfchen- oder Fingerberührungserkennung eine der Verriegelungsfunktionen der primären oder der sekundären Verriegelungsfunktion zu deaktivieren;
und wobei eine erste Taste (16) der kapazitiven Tasten (11- 16) dazu konfiguriert ist, um die Anti-Wisch-Funktion zur Deaktivierung der primären Verriegelungsfunktion zu aktivieren, während eine zweite Taste (15), die nicht die erste Taste (16) ist, konfiguriert ist, um die Anti-Wisch-Funktion zur Deaktivierung der sekundären Verriegelungsfunktion zu aktivieren.

11. Fahrzeugausstattungsteil (2), der mit einem kapazitiven Touchscreen (10) gemäß einem der vorstehenden Ansprüche 1 bis 10 ausgerüstet ist.

12. Fahrzeug (1), das mit einem kapazitiven Touchscreen (10) gemäß einem der vorstehenden Ansprüche 1 bis 10 ausgerüstet ist.

13. Verfahren zur Implementierung eines kapazitiven Touchscreens (10) gemäß einem der vorstehenden Ansprüche 1 bis 9, wobei das Verfahren einen Schritt der selektiven Aktivierung der sekundären Verriegelungsfunktion oder der Anti-Wisch-Funktion des kapazitiven Touchscreens (10) durch Berühren der spezifischen Taste (16) umfasst.

14. Verfahren gemäß Anspruch 13, wobei die Anti-Wisch-Funktion automatisch durch die Tröpfchen- oder Fingerberührungserkennung mittels der spezifischen Taste (16) aktiviert wird, während die sekundäre Verriegelungsfunktion manuell von einem Benutzer aktiviert wird, der über eine passive Zugangsvorrichtung verfügt und die spezifische Taste (16) drückt.

15. Verfahren zur Implementierung eines kapazitiven Touchscreens (10) gemäß Anspruch 10, wobei das Verfahren einen Schritt der Aktivierung der Anti-Wisch-Funktion zur Deaktivierung der primären Verriegelungsfunktion über die Tröpfchen- oder Fingerberührungserkennung mittels der spezifischen Taste (16) oder zur Deaktivierung der sekundären Verriegelungsfunktion über die Tröpfchen- oder Fingerberührungserkennung mittels der zweiten Taste (15) umfasst.

## Revendications

1. Clavier capacitif (10), conçu pour équiper un véhicule (1), comprenant plusieurs touches capacitives (11-16) et configuré pour activer des fonctions particulières, comprenant :
- une fonction de verrouillage principal, consistant à verrouiller ou déverrouiller au moins une ouverture de véhicule ; et
- une fonction de verrouillage secondaire, consistant à verrouiller la au moins une ouverture de véhicule par un utilisateur équipé d'un dispositif d'entrée passif ;
**caractérisé en ce que** les fonctions particulières comprennent en outre une fonction anti-glissement, consistant à désactiver l'une des fonctions de verrouillage parmi la fonction de verrouillage principal et la fonction de verrouillage secondaire, lors d'une détection de gouttelettes ou d'une détection de glissement de doigt ;
et dans lequel une touche spécifique unique (16) parmi les touches capacitives (11-16) est configurée pour activer sélectivement la fonction de verrouillage secondaire ou la fonction anti-glissement du clavier capacitif (10).

2. Clavier capacitif (10) selon la revendication 1, dans lequel la fonction anti-glissement est configurée pour désactiver la fonction de verrouillage principal, lors d'une détection de gouttelettes ou d'une détection de glissement de doigt par la touche spécifique (16).

3. Clavier capacitif (10) selon l'une quelconque des revendications précédentes 1 et 2, dans lequel la fonction anti-glissement est configurée pour désactiver la fonction de verrouillage secondaire, lors d'une détection de gouttelettes ou d'une détection de glissement de doigt par une autre touche (15) que la touche spécifique (16).

4. Clavier capacitif (10) selon la revendication 3, dans lequel l'autre touche (15) est positionnée directement à côté de la touche spécifique (16).

5. Clavier capacitif (10) selon l'une quelconque des revendications précédentes 3 et 4, dans lequel l'autre touche (15) est positionnée directement au-dessus de la touche spécifique (16).

6. Clavier capacitif (10) selon l'une quelconque des revendications précédentes, dans lequel la touche spécifique (16) est positionnée sous d'autres touches capacitives (11-15).

7. Clavier capacitif (10) selon l'une quelconque des revendications précédentes, dans lequel la touche spécifique (16) affiche un symbole de cadenas (61 ; 62).

8. Clavier capacitif (10) selon l'une quelconque des revendications précédentes, dans lequel la touche spécifique (16) affiche un symbole de cadenas fermé (61) lorsque la au moins une ouverture de véhicule est fermée, et un symbole de cadenas ouvert (62) lorsque la au moins une ouverture de véhicule est ouverte.

9. Clavier capacitif (10) selon l'une quelconque des revendications précédentes, dans lequel la fonction de verrouillage principal et la fonction de verrouillage secondaire sont associées à toutes les ouvertures de véhicule, y compris plusieurs portes et au moins un coffre.

10. Clavier capacitif (10), conçu pour équiper un véhicule (1), comprenant plusieurs touches capacitives (11-16), et configuré pour activer des fonctions particulières, comprenant :
- une fonction de verrouillage principal, consistant à verrouiller ou déverrouiller au moins une ouverture de véhicule ; et
- une fonction de verrouillage secondaire, consistant à verrouiller la au moins une ouverture de véhicule par un utilisateur équipé d'un dispositif d'entrée passif ;
**caractérisé en ce que** les fonctions particulières comprennent en outre une fonction anti-glissement, consistant à désactiver l'une des fonctions de verrouillage parmi la fonction de verrouillage principal ou la fonction de verrouillage secondaire, lors d'une détection de gouttelettes ou d'une détection de glissement de doigt ;
et dans lequel une première touche (16) parmi les touches capacitives (11-16) est configurée pour activer la fonction anti-glissement afin de désactiver la fonction de verrouillage principal, tandis qu'une seconde touche (15) différente de la première touche (16) est configurée pour activer la fonction anti-glissement afin de désactiver la fonction de verrouillage secondaire.

11. Composant de garniture de véhicule (2), équipé d'un clavier capacitif (10) selon l'une quelconque des revendications précédentes 1 à 10.

12. Véhicule (1) équipé d'un clavier capacitif (10) selon l'une quelconque des revendications précédentes 1 à 10.

13. Méthode de mise en oeuvre d'un clavier capacitif (10) selon l'une quelconque des revendications précédentes 1 à 9, dans laquelle la méthode comprend une étape d'activation sélective de la fonction de verrouillage secondaire ou de la fonction anti-glissement du clavier capacitif (10) par contact avec la touche spécifique (16).

14. Méthode selon la revendication 13, dans laquelle la fonction anti-glissement est activée automatiquement lors d'une détection de gouttelettes ou d'une détection de glissement de doigt par la touche spécifique (16), tandis que la fonction de verrouillage secondaire est activée manuellement par un utilisateur équipé d'un dispositif d'entrée passif et appuyant sur la touche spécifique (16).

15. Méthode de mise en oeuvre d'un clavier capacitif (10) selon la revendication 10, dans laquelle la méthode comprend une étape d'activation de la fonction anti-glissement pour désactiver la fonction de verrouillage principal lors d'une détection de gouttelettes ou d'une détection d'un glissement de doigt par la première touche (16) ou pour désactiver la fonction de verrouillage secondaire lors d'une détection de gouttelettes ou d'une détection de glissement de doigt par la seconde touche (15).
